# EUROPÄISCHE PATENTSCHRIFT

(11) **EP 0 723 339 B1**
(45) Veröffentlichungstag und Bekanntmachung des Hinweises auf die Patenterteilung: **07.04.1999**
(21) Anmeldenummer: 96100565.9
(22) Anmeldetag: 16.01.1996
(51) Int. Cl.: H03K 17/96

(54) **Verfahren und Schaltungsanordnung für einen kapazitiven, digitalen Sensorschalter**
Method and circuit for a capacitive digital sensor switch
Procédé et circuit pour un capteur commutateur capacitif digital

(30) Priorität: 17.01.1995 DE 19501232
(43) Veröffentlichungstag der Anmeldung: 24.07.1996
(73) Patentinhaber: Dickfeld, Erich, 01979 Lauchhammer (DE)
(72) Erfinder: Dickfeld, Erich, 01979 Lauchhammer (DE)
(74) Vertreter: Kailuweit, Frank, Dr. Dipl.-Ing.

(56) Entgegenhaltungen:
- DE-A- 2 516 024
- US-A- 3 668 660

## Beschreibung

Die Erfindung betrifft ein Verfahren zur Auswertung einer Sensorkapazität in einem kapazitiven Sensorschalter und eine Schaltungsanordnung zu dessen Durchführung.

Neben der meßtechnischen Erfassung von Kapazitäten sind aus der Sensorik kapazitive Annährungsschalter bekannt, die in ein High/Low-Signal wandeln, wobei die Sensorfläche oftmals an der Stirnseite eines kompakten Gehäuses angeordnet ist und ihre Kapazität zur Gehäusemasse die Schwingbedingung beeinflußt. Ein solcher Aussetzoszillator muß unmittelbar am Meßort installiert werden, eine örtliche Trennung von Sensorfläche und Auswerteelektronik wird wegen des empfindlichkeitsmindernden Einflusses parasitärer Kapazitäten vermieden.
Induktivitäten und Mittkopplungseffekte bei Tastaturanordnungen zwingen zu selektiven Lösungen, schaffen Abgleich- und Positionierungsprobleme und stehen dem Trend zur Miniaturisierung entgegen. Prinzipbedingt erreichen sie nur geringe Schaltfolgefrequenzen und reagieren empfindlich auf Fremdfelder und die Anwesenheit von Wasser mit seiner hohen Dielektrizitätskonstanten.

Aus der Druckschrift DE 4006119 A1 ist bekannt, daß die aktive Elektrode eines kompakten kapazitiven Wegaufhehmers aus Oszillator, Sende- und Empfangskapazität, Demodulator und Schaltverstärker bestehend, durch eine Abschirmelektrode ergänzt wurde, um den Einfluß von Wasser zu reduzieren und statische Kapazitäten abzuschirmen.
Aus der Druckschrift DE-G 9403322.6 ist eine Berührungsschalterplatte bekannt, deren selektive Elektronik unmittelbar hinter den Elektroden auf einer flexiblen Leiterplatte angeordnet ist, um so eine anschmiegsame, flächenhafte Verklebung mit einer gekrümmten Vorderplatte zu erzielen.

In der Druckschrift EP-P 517745 wird eine kapazitive Schaltungskarte mit einer speziellen Schichtenstruktur aus Leiterbahnengitter und Schirmflächen bei Verwendung unterschiedlich leitfähiger Materialien beschrieben, um parasitäre Koppelelemente in ihrem Einfluß zurückzudrängen und dennoch ein auswertbares Signal für nachgeordnete Verstärker zu erhalten.

In der Druckschrift WO 95/19661 wird eine kapazitive Auswertung eines Armährungskissens beschrieben, das unmittelbar an den Eingang eines Schmitt-Triggers angeschlossen ist. Mit einem Einstellregler wird eine Koinzidenzschaltung abgeglichen. Wechselnde Umgebungsverhältnisse führen entweder zur Fehlauslösung oder zum Empfindlichkeitsverlust.

Alternativ zu kapazitiven Sensoren werden mechanische Kontakte und Schalter als Eingabeelemente von Informationen mit nicht unerheblichem technischen Aufwand durch magnetische, optische und andere Sensoren ersetzt. Die Druckschrift EP-A 618680 beschreibt, wie durch eine Glasscheibe hindurch aus der Reflexion eines Infrarotstrahles, z. B. an einem sich nähernden Finger, ein Ausgangssignal sicher abgeleitet wird.

Bei allen recherchierten Lösungen erweist es sich als nachteilig, am Eingabeort einer Information rückseitig einer Gehäusewandung elektronische Wandler anordnen zu müssen sowie ihre Stromversorgung sicherzustellen. Die bekanntgewordenen kapazitiven Systeme besitzen darüber hinaus den Nachteil, bei kapazitiven Änderungen im Detektionsbereich sowie bei Anwesenheit von dielektrischen Stoffen die Schalteigenschaften zu ändern. In der Druckschrift DE-OS 4310910 A1 wird zwar vorgeschlagen, den für die Stromversorgung nötigen dritten Leitungsdraht einzusparen und die Versorgungsspannung für einen induktiven Geber über die beiden Informationsleitungen zu beziehen. Dieser Vorschlag stellt lediglich eine Teillösung der technischen Aufgabe dar.

Ein Verfahren zur Auswertung einer Sensorkapazität gemäß dem Oberbegriff des Anspruchs 1 und eine Schaltungsanordnung gemäß dem Oberbegriff des Anspruchs 2 sind aus DE-A-2 516 024 bekannt.

Die Aufgabe der Erfindung besteht darin, einen vorzugsweise durch die Annäherung eines Körperteiles oder eines bewegten Gegenstandes ausgelösten Verschiebungsstromanteil durch eine nichtleitende Schicht hindurch von einer Auffangelektrode aus hinreichend weit an eine beliebige Stelle transportieren und erst dort auswerten zu können, ohne in unmittelbarer Nähe der Auffangelektrode Wandler anordnen zu müssen. Die Auswerteelektronik soll dabei Umfeldkapazitäten ignorieren, Störspannungen austasten und sowohl kompatibel zur weiterverarbeitenden Informationselektronik als auch mit ihr integrierbar sein.

### Darstellung der Erfindung

Erfindungsgemäß wird die Aufgabe durch die Merkmale des Verfahrens gemäß Anspruch 1 bzw. die Merkmale der Schaltungsanordnung gemäß Anspruch 2 gelöst. Besondere Ausführungsarten der Schaltungsanordnung der Erfindung sind in den Ansprüchen 3 bis 10 angegeben.

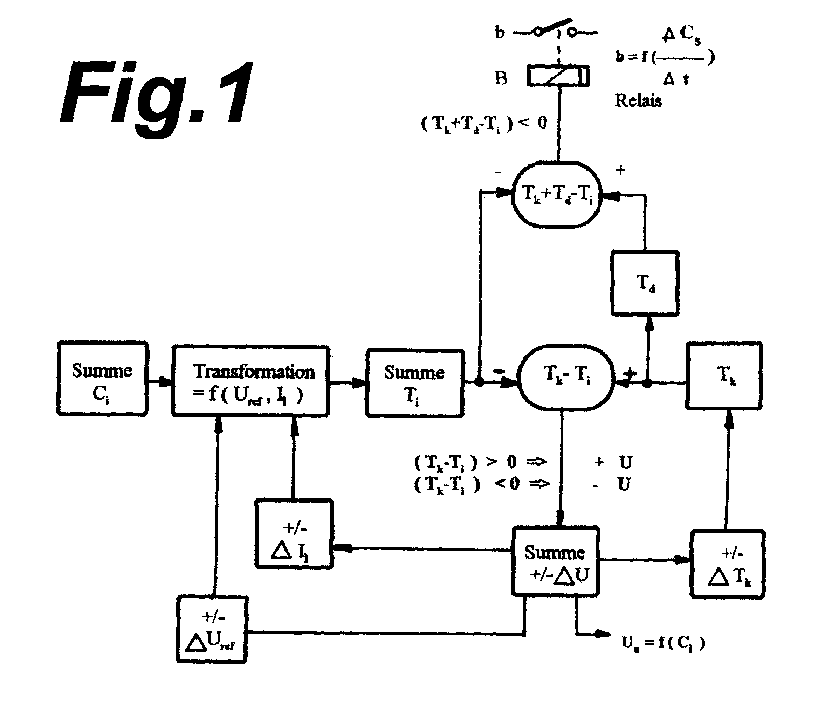

Die regelbaren Größen werden somit innerhalb eines Regelkreises mit integralem Anteil als Stellgrößen benutzt, wobei in einem ersten Zeitvergleicher die tatsächliche Ladezeit mit einer Zeitreferenz verglichen wird und das digitale Ausgangssignal über einen einstellbaren Stromgenerator einen Speicherkondensator auf- oder entladet. Die sich an ihm einstellende Spannung wird in einem Spannungs-Stromwandler bzw. Spannungs-Spannungswandler zur Erzeugung
a) der regelbaren Zeitreferenz,
b) des regelbaren Ladestromes,
c) der regelbaren Referenzspannung
benutzt. Es können mehrere Regelschleifen gleichzeitig wirken, z. B. a) + b) + c), wobei sich der erzielbare Dynamikbereich zur Kompensation der statistischen Kapazitäten vergrößert. Die Umladegeschwindigkeit der Speicherkondensatorspannung ist wählbar, ihre Größe ein Maß für die wirksamen statischen Kapazitäten.
Wird bei Annäherung einer Hand oder eines Fingers an die Sensorfläche der Regelkreis schneller verstimmt als die Regelgeschwindigkeit dies ausgleichen kann, gibt ein zweiter Zeitvergleicher ein Ausgangssignal ab, wenn die Zeitdifferenz zwischen Aufladezeit und Referenzzeit ein weiteres, einstellbares Zeitmaß Td überschreitet (vgl. Fig. 1).

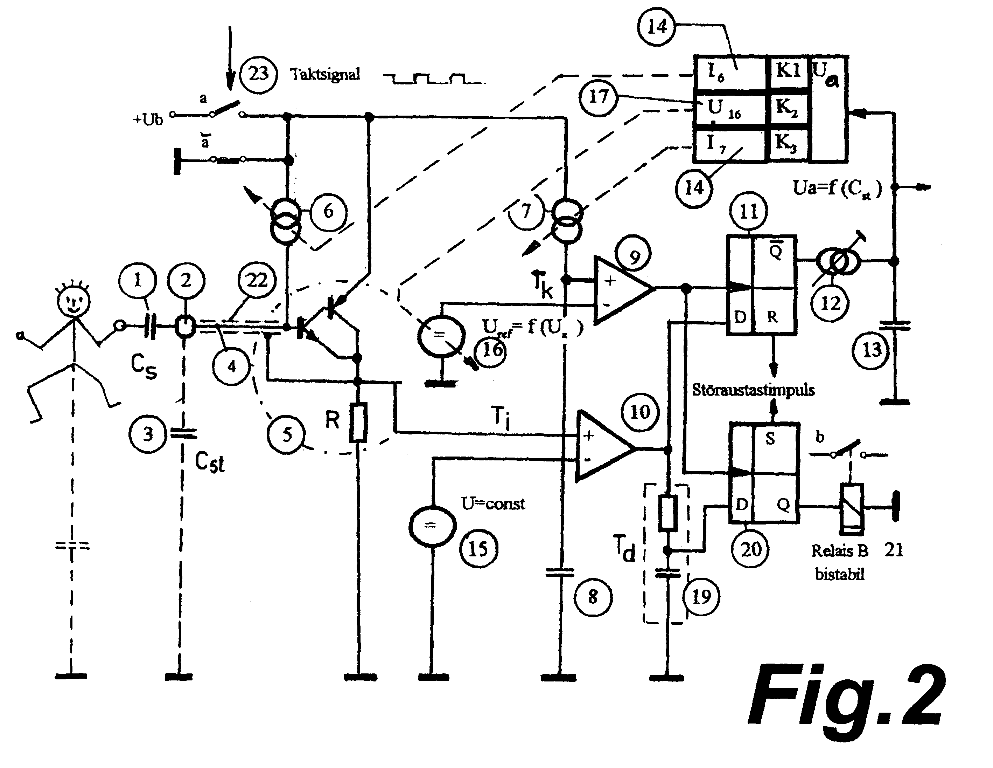

Die Empfindlichkeit der Anordnung ist von der Zeitauflösung des Zeitvergleichers bestimmt.
Die steuerbaren Stromgeneratoren in **Figur 2** können im einfachsten Fall eines Ausführungsbeispieles auch durch Widerstände ersetzt werden, wobei dann die antreibende Spannung proportional der Ladespannung des Ladekondensators sein muß.

Weiterhin wurde gefunden, die Abschirmung der Streifenleitung mit dem elektronisch erzeugten geringen Innenwiderstand des Emitterfolgerausganges abzuschließen. In einer weiteren vorteilhaften Ausgestaltung der Erfindung kann das Taktsignal mit der Netzwechselspannung synchronisiert sein, wobei es in Zeitbereiche mit geringer Spannungsänderung gelegt ist.
Es wurde weiterhin gefunden, Störspannungsspitzen auf der Netzwechselspannung auszufiltern, einem Trigger zuzuführen und mit seinem Ausgangssignal über eine negative Regelabweichung eine Empfindlichkeitsanpassung zu bewirken und zur Vermeidung von Fehlschaltungen die Abgabe eines Ausgangssignales zu unterbinden.

In einer alternativen Ausgestaltung des Emitterfolgers mit einem rein kapazitiven Emitterwiderstand wurde gefunden, daß nach hinreichend langer Zeit sich am Emitter eine Grenzspannung einstellt, die ein Maß für den ohmschen Verlustwiderstand Rₛₜ vorzugsweise der statischen Kapazität Cₛₜ darstellt. Weiterhin wurde gefunden, daß ein kapazitiver Emitterwiderstand eine automatische Strombegrenzung der Emitterfolgerstufe bewirkt.

Die mit der Erfindung erzielten Vorteile resultieren aus dem Ersatz des Schwingoszillatorprinzips durch das erfindungsgemäße Schalterprinzip.
Einmal werden relativ kleine Kapazitäten durch relativ hohe Ströme in wenigen Mikrosekunden aufgeladen und sofort wird ein Ausgangssignal erzeugt; hohe Schaltfolgefrequenzen sind möglich. Des weiteren werden auf einfache Weise eine dynamische Störaustastung und Empfindlichkeitsanpassung erreicht, bei analogen Systemen kaum realisierbar.
Regelkreise kompensieren den Einfluß von statischen Störgrößen wie Wasser und wechselnden kapazitiven Umgebungsbedingungen. Ein Systemabgleich ist nicht mehr erforderlich. Als Folge kann der Verschiebungsstrom über die Sensorkapazität in den gesamten menschlichen Körper und über seine Volumenkapazität von 100 bis 200 Picofarad nach Masse abfließen.
Speziell geformte Auffang- und Abschirmelektroden werden überflüssig. Ein Tropfen leitfähiger Kleber oder eine selbstklebende metallisierte Folie, beides mit der Streifenleitung elektrisch verbunden, genügen. Dynamische Störinfluenzen, die auf die Abschirmung der Streifenleitung einwirken, werden über den niedrigen elektronischen Innenwiderstand des Spannungsfolgerausganges nach Masse abgeleitet. Der wirksame Kapazitätsbelag der Streifenleitung wird reduziert. Als Folge entfallen Wandler und damit naturgemäß Energiezuführungsleitungen in die Nähe der Sensorelektrode.

Die Streifenleitung kann als metallisierte Bahn auf der Rückseite eines selbstklebenden Folienstreifens geringster Dicke flexibel ausgeführt werden. Eine problemlose Verlegung unter Tapeten, Ausbauplatten oder Fliesenflächen ist möglich.
Vorteilhaft ist auch die Anwendung des kapazitven Sensors in Feuchträumen, wie Bädern, Toiletten, Saunen oder Schwimmhallen.
In Betonplattenbauwerken werden bei Einsatz des Sensors aufwendige Aufputzinstallationen für elektrische Lichtschalter verzichtbar.

Wie noch gezeigt wird, ist eine der statischen kapazitiven Störgröße proportionale Spannung abgreifbar. So kann auch ein Einsatz als kapazitiver Wegaufnehmer mit dem Vorteil hoher Auflösung bei frei wählbarer Taktsequenz erfolgen.

Erfindungsgemäß ist der kapazitive, digitale Sensorschalter vorzugsweise mit der C-MOS-Familie 74 HC XX.. aufgebaut, womit er bei kleinen Betriebsspannungen von 2 Volt an zu den Low-Power-Systemen gerechnet werden kann. Sein Versorgungsstrom kann aus dem 220 Volt-Netz kapazitiv ausgekoppelt werden, womit kleinste Baueinheiten realisierbar sind.
Die beschriebene alternative Ausgestaltung der Emitterfolgestufe ermöglicht bei geringem Strombedarf eine automatische Überwachung der parallelen ohmschen Verlustwiderstände von Meßkapazität und statischer Kapazität sowie eine Störanzeige.

Digitale Informationsaufbereitung, Selbstjustage, Eigensicherheit und Integrierbarkeit prädestinieren den digitalen, kapazitiven Sensorschalter geradezu für eine automatische Fertigung.
Nach dem Blockschaltbild in **Figur 1** besteht das Wesentliche des Verfahrens in der Transformation der kapazitiven Größen Cᵢ in Zeitgrößen Tᵢ, wobei sie mit einem Zeitmaß Tₖ im ersten Zeitvergleicher verglichen werden. Sein Ausgangssignal wirkt innerhalb eines Regelkreises auf eine integrierende Speichergröße ein, die wiederum den Transformationsgrad durch Änderung des Ladestromes, der Referenzspannungen oder des Referenzzeitraumes so verändert, daß eine Regelabweichung Null wird.
Nur wenn das Zeitmaß Tᵢ größer ist als die Zeitmaße T_{d} und Tₖ zusammen, wird über einen zweiten Zeitvergleicher ein Relais angesteuert. Diese Zunahme um das Zeitmaß T_{d} muß schneller erfolgen als die Regelgeschwindigkeit diese Regelabweichung kompensieren kann.

### Ausführungsbeispiel

Anhand der **Figur 2** soll ein Ausführungsbeispiel erläutert werden.
Während eines positiven Taktimpulses (23) laden die regelbaren Stromquellen (6) und (7) sowohl die Summenkapazität C_{i,} aus Sensorkapazität C_{S} (1) und statischer Kapazität Cₛₜ (3) bestehend, als auch eine Kapazität (8) auf.
Die Aufladespannung an der Summenkapazität Cᵢ wird durch eine abgeschirmte Leitung (4) über den Emitterfolger (5) an den +Eingang des Komperators (10) und die Ladespannung der Kapazität (8) an den +Eingang eines zweiten Komperators (9) geführt.
Die Referenzspannung des Komperators (9) ist geregelt und die des Komperators (10) fest eingestellt. Erreichen die Aufladespannungen die jeweiligen Schwellwerte der Komperatoren, werden ihre Low/High-Ausgangssignale vom Zeitvergleicher (11) in Abhängigkeit ihrer Zeitbezüge zueinander bis zum folgenden Taktsignal in High- oder Low-Signale gewandelt.

Über einen einstellbaren Stromgenerator (12) wird eine integrierende Speicherkapazität (13) auf- oder entladen. Ihre Spannung steuert über Spannungs-Stromwandler (14) die regelbaren, getakteten Stromgeneratoren (6) und (7) bzw. über Spannungs-Spannungswandler (17) die regelbare Referenzspannung (16).
Jede geregelte Größe bildet ein Stellglied in einem Regelkreis mit der gleichartigen Wirkung, die Zeitdifferenz zwischen den Low/High-Signalen an den Komperatorausgängen gegen Null auszuregeln.
Alle Regelkreise addieren ihre Regeldynamik zur Kompensation der statischen Kapazität Cₛₜ. So wird ein Selbstabgleich der Anordnung in weiten Grenzen möglich.
Die Regelgüte ist von der Zeitauflösung der Zeitvergleicherstufe (11) bestimmt und die Regelgeschwindigkeit von der Umladezeit des Speicherkondensators (13).
Können schnelle Kapazitätsänderungen an der Sensorkapazität C_{S} nicht mehr ausgeregelt werden und wird dabei die Zeitdifferenz zwischen den Komperatorausgangssignalen größer als eine Verzögerungszeit im Zeitglied (19), schaltet der Zeitvergleicher (20) ein bistabiles Relais. Bei einer wiederholten, schnellen Handannäherung erfolgt ein Rücksetzen (Bewegungsmelder). Langsamer Kapazitätszuwachs wird schnell genug ausgeregelt und bildet sich als Spannungsänderung am Speicherkondensator (13) ab (Analogsensor).

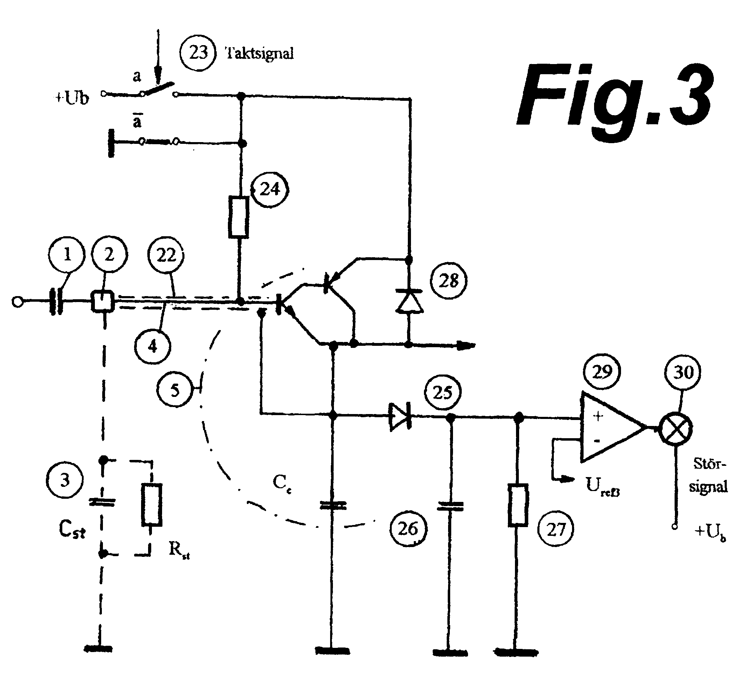

In **Figur 3** ist eine alternative Ausgestaltung der Emitterfolgeeingangsstufe (5) mit einem kapazitiven Emitterwiderstand und einer Spitzenspannungsgleichrichtung mit den Elementen (25), (26) und (27) dargestellt.
Vorteilhaft ist hierbei eine automatische Strombegrenzung in dieser Stufe nach erfolgtem Aufladevorgang und eine sich einstellende Emitterspannung, die der Spannungsteilung zwischen Ladewiderstand (24) und dem ohmschen Verlustwiderstand Rₛₜ parallel zur
statischen Kapazität (3) proportional ist. Unterschreitet sie eine Referenzspannung U_{ref3,} so schaltet der Komperator (29) die Störanzeige (30) ein.
Mit dieser Anordnung kann die Hochohmigkeit der Meßstrecke überwacht und Eigensicherheit erzielt werden. Die Diode (28) dient zur Entladung der Leitung (4) und der Ermitterkapazität Cₑ während der Low-Phase des Taktes. Während der High-Phase des Taktes werden Störinfluenzen auf der Abschirmung (22) über den geringen dynamischen
Innenwiderstand der Emitterfolgestufe (5) abgeleitet und der wirksame Kapazitätsbelag der Leitung reduziert.
Werden zusätzlich die Regelungsvarianten b) und c) schaltungstechnisch realisiert, erhöht sich die Regeldynamik.

## Patentansprüche

1. Verfahren zur Auswertung einer Sensorkapazität (C_{S}) in einem kapazitiven Sensorschalter,
wobei die Auswerteelektronik örtlich getrennt von einer Sensorfläche (2) angeordnet wird,
und wobei ein Aufladungszeitmaß Tᵢ zur Aufladung mit einem Ladestrom (I₆) einer Summenkapazität (Cᵢ), gebildet von den kapazitiven Größen aus Sensorkapazität (Cₛ) und wirksamer statischer Kapazität (Cₛₜ), bis auf eine Referenzspannung (U=const) erfaßt wird,
**dadurch gekennzeichnet,**
daß das Zeitmaß Tᵢ von einem Zeitmaß Tₖ in einem Zeitvergleicher (11) substrahiert wird, wobei sich ein Differenzzeitmaß Tₖ - Tᵢ ergibt, das zur dynamischen Kompensation der statischen Kapazität eine Speichergröße verändert, deren Wert die Größe des Zeitmaßes Tₖ und/oder die Größe des Ladestromes (I₆) derart regelt, daß das Differenzzeitmaß gegen Null ausgeregelt wird, und daß in einem weiteren Zeitvergleicher (20) ein Ausgangssignal abgegeben wird, wenn das Zeitmaß Tᵢ größer als das Zeitmaß Tₖ zuzüglich eines weiteren, wählbaren Zeitmaßes T_{d} wird.

2. Schaltungsanordnung zur Auswertung einer Sensorkapazität (C_{S}) in einem kapazitiven Sensorschalter,
**dadurch gekennzeichnet,**
daß eine Sensorkapazität (Cₛ), von einer Sensorfläche (2) gegen die leitfähige Oberfläche einer sich nähernden Hand oder eines Körperteiles oder eines Gegenstandes gebildet, zusammen mit einer wirksamen statischen Kapazität (Cₛₜ) über eine Leitung (4) mit dem Eingang einer Emitterfolgestufe (5) und mit einem getakteten, regelbaren, ersten Stromgenerator (6) verbunden ist,
daß gleichzeitig eine Kapazität (8) mit einem getakteten, regelbaren, zweiten Stromgenerator (7) und
mit dem positiven Eingang eines ersten Komparators (9) verbunden ist, wie der Ausgang der Emitterfolgestufe (5) mit dem positiven Eingang eines zweiten Komparators (10) verbunden ist,
und daß die Referenzeingänge der ersten und zweiten Komparatoren (9 und 10) mit einer Konstantspannung (15) bzw. einer regelbaren Referenzspannung (U_{ref}) einer regelbaren Spannungsquelle (16) verbunden sind,
wobei beide Komparatorausgänge verbunden sind mit einem ersten Zeitvergleicher (11), dessen Ausgang über einen einstellbaren Stromgenerator (12) einen Speicherkondensator (13) speist, dessen Spannung über einen
mehrkanaligen Wandler (14) die regelbaren Ströme der Stromgeneratoren (6,7) und die regelbare Referenzspannung (U_{ref}) der Spannungsquelle (16) generiert und sie als Stellgrößen in gleichviele Regelkreise mit sich summierender Regeldynamik zur
Kompensation der statischen Kapazität (3) einbindet, und daß weiterhin der Komparatorausgang des ersten Komparators (9) direkt und der Komparatorausgang des zweiten Komparators (10) über ein Verzögerungsglied (19) einen zweiten Zeitvergleicher (20) ansteuern und dieser ein bistabiles Relais (B) schaltet.

3. Schaltungsanordnung nach Anspruch 2,
**dadurch gekennzeichnet,**
daß der Ausgang der Emitterfolgestufe (5) mit einer Abschirmung (22) der Leitung (4) verbunden ist.

4. Schaltungsanordnung nach Anspruch 3,
**dadurch gekennzeichnet,**
daß die Leitung (4) und die Abschirmung (22) als Streifenleitung auf flexiblen Plastikfolienstreifen ausgeführt ist.

5. Schaltungsanordnung nach Anspruch 2,
**dadurch gekennzeichnet,**
daß die Sensorfläche (2) aus einem leitfähigen Kleber besteht.

6. Schaltungsanordnung nach Anspruch 2 oder 5,
**dadurch gekennzeichnet,**
daß die Sensorfläche (2) aus einer leitfähigen Folie ohne Abschirmelektroden oder Kompensationselektroden besteht und sie ohne Zwischenwandler direkt über eine abgeschirmte Leitung (4) mit der Auswerteelektronik verbunden ist.

7. Schaltungsanordnung nach Anspruch 2,
**dadurch gekennzeichnet,**
daß das Taktsignal (23) mit einer Netzwechselspannung synchronisiert ist und in Zeiträumen geringer Netzwechselspannungsänderungen auftritt.

8. Schaltungsanordnung nach Anspruch 2,
**dadurch gekennzeichnet,**
daß Störspannungen auf einer Netzversorgungswechselspannung ausgefiltert sowie einem Schmitt-Trigger zugeführt werden, dessen Ausgangssignal den zweiten Zeitvergleicher (20) über die Setz- oder Rücksetzeingänge blockiert.

9. Schaltungsanordnung nach Anspruch 2,
**dadurch gekennzeichnet,**
daß Störspannungen auf einer Netzversorgungswechselspannung ausgefiltert sowie einem Schmitt-Trigger zugeführt werden, dessen Ausgangssignal eine negative Regelabweichung über die Setz- und Rücksetzeingänge des ersten Zeitvergleichers (11) bewirkt.

10. Schaltungsanordnung nach Anspruch 2,
**dadurch gekennzeichnet,**
daß in der Emitterfolgestufe (5) der Emitter mit einer Kapazität (Cₑ) verbunden ist und daß der erste Stromgenerator (6) aus einem Ladewiderstand (24) besteht, wobei
die maximale Ausgangsspannung der Emitterfolgestufe (5) über eine Spitzenwertgleichrichtung durch einen weiteren Komperator (29) überwacht und ein Absinken unter eine Referenzspannung (U_{ref3}) angezeigt wird.

## Claims

1. Method for the evaluation of a sensor capacitance (C_{S}) in a capacitive sensor switch, the evaluation electronics being located locally separated from a sensor surface (2) and a charging time measurement Tᵢ for charging with a charging current (I₆) of a total capacitance (Cᵢ), formed by the capacitive quantities of sensor capacitance (Cₛ) and effective static capacitance (Cₛₜ), up to a reference voltage (U=const) being ascertained, characterised in that the time measurement Tᵢ is subtracted from a time measurement Tₖ in a time comparator (11), a differential time measurement T_{K} - Tᵢ resulting, which for the dynamic compensation of the static capacitance alters a memorised quantity, whereof the value controls the quantity of the time measurement Tₖ and/or the quantity of the charging current (I₆) so that the differential time measurement is stabilised towards zero, and that in a further time comparator (20) an output signal is emitted, when the time measurement Tᵢ becomes greater than the time measurement Tₖ plus a further time measurement T_{d} which can be selected.

2. Circuit for the evaluation of a sensor capacitance C_{S} in a capacitive sensor switch, characterised in that a sensor capacitance (C_{S}), formed by a sensor surface (2) with respect to the conducting surface of an approaching hand or a body part or an object, together with an effective static capacitance (Cₛₜ) is connected by way of a lead (4) to the input of an emitter subsequent stage (5) and to a timed, controllable, first current generator (6), and that a capacitance (8) is connected to a timed, controllable, second current generator (7) and to the positive input of a first comparator (9) at the same time as the output of the emitter subsequent stage (5) is connected to the positive input of a second comparator (10) and that the reference inputs of the first and second comparators (9 and 10) are connected to a constant voltage (15) or an adjustable reference voltage (U_{ref}) of an adjustable voltage source (16), both comparator outputs being connected to a first time comparator (11), whereof the output, by way of an adjustable current generator (12), supplies a storage capacitor (13), whereof the voltage by way of a multi-channel converter (14) generates the adjustable currents of the current generators (6, 7) and the adjustable reference voltage (U_{ref}) of the voltage source (16) and introduces them as control variables into the same number of control circuits with totalising control dynamics for the compensation of the static capacitance (3), and that furthermore the comparator output of the first comparator (9) controls directly and the comparator output of the second comparator (10), by way of a delay member (19), controls a second time comparator (20) and the latter switches a bistable relay (B).

3. Circuit according to Claim 2, characterised in that the output of the emitter subsequent stage (5) is connected to screening (22) of the lead (4).

4. Circuit according to Claim 3, characterised in that the lead (4) and the screening (22) are constructed as a strip lead on flexible plastic foil strips.

5. Circuit according to Claim 2, characterised in that the sensor surface (2) consists of a conducting adhesive.

6. Circuit according to Claim 2 or 5, characterised in that the sensor surface (2) consists of a conducting foil without screening electrodes or compensation electrodes and it is connected without an intermediate converter directly by way of a screened lead (4) to the evaluation electronics.

7. Circuit according to Claim 2, characterised in that the timing signal (23) is synchronised with the mains alternating voltage and occurs in periods of low mains alternating voltage changes.

8. Circuit according to Claim 2, characterised in that interference voltages on a mains supply alternating voltage are filtered out and supplied to a Schmitt Trigger, whereof the output signal blocks the second time comparator (20) by way of the setting or resetting inputs.

9. Circuit according to Claim 2, characterised in that interference voltages on a mains supply alternating voltage are filtered out and supplied to a Schmitt Trigger, whereof the output signal brings about a negative control deviation by way of the setting and resetting inputs of the first time comparator (11).

10. Circuit according to Claim 2, characterised in that in the emitter subsequent stage (5), the emitter is connected to a capacitance (Cₑ) and that the first current generator (6) consists of a charging resistor (24), the maximum output voltage of the emitter subsequent stage (5) being monitored by way of peak value rectification by a further comparator (29) and a drop below a reference voltage (U_{ref3}) being indicated.

## Revendications

1. Procédé d'exploitation d'une capacité de capteur (C_{S}) dans un capteur commutateur capacitif, selon lequel on dispose l'électronique d'exploitation localement séparée d'une surface de capteur (2) et selon lequel on détecte une mesure de temps de charge Tᵢ pour charger, par un courant de charge (I₆), une capacité cumulée (Cᵢ), constituée par les grandeurs capacitives de la capacité de capteur (C_{S}) et de la capacité statique efficace (Cₛₜ), jusqu'à une tension de référence (U = const),
caractérisé en ce
que l'on déduit la mesure de temps Tᵢ d'une mesure de temps Tₖ dans un comparateur de temps (11), ce qui four; nit une mesure de différence de temps Tₖ - Tᵢ, laquelle change, en vue de la compensation dynamique de la capacité statique, une grandeur d'emmagasinage dont la valeur règle la grandeur de la mesure de temps Tₖ et/ou l'intensité du courant de charge (I₆), de manière que la mesure de différence de temps soit ramenée par la régulation vers zéro, et qu'un autre comparateur de temps (20) délivre un signal de sortie lorsque la mesure de temps Tᵢ devient plus grande que la mesure de temps Tₖ plus une autre mesure de temps T_{d} sélectionnable.

2. Circuit d'exploitation d'une capacité de capteur (C_{S}) dans un capteur commutateur capacitif,
caractérisé en ce
qu'une capacité de capteur (C_{S}), d'une surface de capteur (2) par rapport à la surface conductrice d'une main ou d'une autre partie d'un corps ou d'un objet qui s'approche, ensemble avec une capacité statique efficace (Cₛₜ), est connectée par une ligne (4) à l'entrée d'un étage émetteur-suiveur (5) et à un premier générateur de courant (6) cadencé réglable,
qu'une capacité (8) est connectée en même temps à un second générateur de courant (7) cadencé réglable et à l'entrée positive d'un premier comparateur (9), tandis que la sortie de l'étage émetteur-suiveur (5) est connectée à l'entrée positive d'un second comparateur (10),
et que les entrées de référence des premier et second comparateurs (9 et 10) sont connectées à une tension constante (15) ou une tension de référence (U_{ref}) réglable d'une source de tension réglable (16),
les deux sorties de comparateur étant connectées à un premier comparateur de temps (11) dont la sortie alimente, à travers un générateur de courant (12) ajustable, un condensateur d'emmagasinage (13) dont la tension génère, à travers un transducteur (14) à plusieurs canaux, les courants réglables des générateurs de courant (6, 7) et la tension de référence (U_{ref}) réglable de la source de tension (16) et les introduit en tant que grandeurs réglantes en autant de circuits de régulation à dynamique de régulation sommatrice en vue de la compensation de la capacité statique (3),
et que, en outre, la sortie du premier comparateur (9) commande directement et la sortie du second comparateur (10) commande à travers un élément à retard (19) un second comparateur de temps (20), lequel commute un relais bistable (B).

3. Circuit selon la revendication 2, caractérisé en ce que la sortie de l'étage émetteur-suiveur (5) est connectée à un blindage (22) de la ligne (4).

4. Circuit selon la revendication 3, caractérisé en ce que la ligne (4) et le blindage (22) sont réalisés comme une ligne en ruban sur une bande flexible de feuille de matière plastique.

5. Circuit selon la revendication 2, caractérisé en ce que la surface de capteur (2) est constituée d'une colle conductrice.

6. Circuit selon la revendication 2 ou 5, caractérisé en ce que la surface de capteur (2) est constitué d'une feuille conductrice sans électrodes de blindage ou de compensation et qu'elle est connectée directement, sans transducteur intermédiaire, à l'électronique d'exploitation par une ligne (4) blindée.

7. Circuit selon la revendication 2, caractérisé en ce que le signal d'horloge (23) est synchronisé avec la tension alternative du secteur et apparaît dans des périodes à faibles variations de la tension alternative du secteur.

8. Circuit selon la revendication 2, caractérisé en ce que des tensions perturbatrices sur une tension alternative d'alimentation à partir du secteur sont séparées par filtrage et envoyées à une bascule de Schmitt dont le signal de sortie bloque le second comparateur de temps (20) à travers les entrées de mise à 1 ou de remise à 0.

9. Circuit selon la revendication 2, caractérisé en ce que des tensions perturbatrices sur une tension alternative d'alimentation à partir du secteur sont séparées par filtrage et envoyées à une bascule de Schmitt dont le signal de sortie produit une déviation de réglage négative à travers les entrées de mise à 1 et de remise à 0 du premier comparateur de temps (11).

10. Circuit selon la revendication 2, caractérisé en ce que, dans l'étage émétteur-suiveur (5), l'émetteur est connecté à une capacité (Cₑ) et que le premier générateur de courant (6) est constitué d'une résistance de charge (24), la tension de sortie maximale de l'étage émetteur-suiveur (5) étant surveillée à travers un redressement de valeurs de crête par un autre comparateur (29) et un abaissement au-dessous d'une tension de référence (U_{ref3}) étant indiqué.
